# EUROPÄISCHE PATENTSCHRIFT

(11) **EP 1 213 954 B1**
(45) Veröffentlichungstag und Bekanntmachung des Hinweises auf die Patenterteilung: **19.01.2011**
(21) Anmeldenummer: 00126240.1
(22) Anmeldetag: 01.12.2000
(51) Int. Cl.: H05K 13/04, H01R 13/514

(54) **Verfahren und Montage elektrischer Bauelemente auf einer Leiterplatte, Stiftleiste und Bestückungskopf**
Method and mounting of electrical components on a printed circuit, pin connector and mounting head
Méthode et montage de composants électriques sur un circuit imprimé, connecteur à broches en rangée et tête de montage

(43) Veröffentlichungstag der Anmeldung: 12.06.2002
(73) Patentinhaber: Weidmüller Interface GmbH & Co. KG, 32758 Detmold (DE)
(72) Erfinder: Endres, Klaus, 63347 Maintal (DE); Lange, Manfred, 64560 Riedstadt (DE); Radde, Werner, 64832 Babenhausen (DE); Sturm, Michael, 64347 Griesheim (DE); Wägner, Ralf, 64854 Otzberg (DE); Kowolik, Rudolf, 63225 Langen (DE)
(74) Vertreter: Specht, Peter

(56) Entgegenhaltungen:
- DE-U- 9 004 833
- US-A- 5 074 030
- US-A- 5 951 306

## Beschreibung

Die Erfindung betrifft ein Verfahren zur Montage elektrischer aktiver oder passiver Baulemente auf einer Leiterplatte sowie einen Bestückungskopf eines Bestückungswerkzeuges zur Bildung einer Stiftleiste.

Bei der Herstellung von elektrischen und elektronischen Bauelementen - beispielsweise Leiterplatten für Anwendungen in der Tele- und Datenkommunikation - wachsen ständig die Anforderungen an die Miniaturisierung und die Funktionsintegration. Diesen Anforderungen unterliegen auch die Steckverbinder der Bauelemente bzw. Leiterplatten. So werden bei vielen Anwendungen Steckverbinder bzw. Stiftleisten mit einer Pinanzahl zwischen 2 und 24 eingesetzt. Es werden aber mittlerweile auch Stifleisten gefordert, die Pinanzahlen von 400 bis 800 Kontakten pro 100 mm Kartenlänge bzw. Leiterplattenlänge aufweisen. Nach dem Stand der Technik werden selbst derart hochpolige Stiftleisten nach ihrer Herstellung als Ganzes auf eine Leiterplatte aufgesetzt. Um die Variantenvielfalt einzuschränken (Logistik) wird nunmehr versucht, hochpolige Stiftleisten aus mehrpoligen zusammenzustellen. Dabei tritt allerdings der problematische Effekt auf, daß dann, wenn die einzelnen Steckerstifte oder Pins nicht exakt in einer Reihe ausgerichtet sind, sowohl die Montage auf der Leiterplatte als auch der Anschluß einer Steckerbuchse an den Steckverbinder nur sehr schwer oder gar nicht zu realisieren ist, da die Steckerpins nicht genau in die entsprechenden Öffnungen der Steckerbuchse eingreifen. Zudem vermitteln Stiftleisten mit nicht exakt gerade ausgerichteten Pins den optischen Eindruck mangelhafter Qualität selbst dann, wenn die Funktionalität noch gewährleistet ist.

Ein solches Verfahren ist aus dem Dokument US-A-5 951 306 bekannt.

Vor dem Hintergrund der vorstehend beschriebenen Problematik zielt die Erfindung darauf ab, ein Verfahren zur Montage elektrischer Baulemente auf einer Leiterplatte mit denen auf einfache und unkomplizierte Weise eine weitestgehend exakte Ausrichtung des Bauelementes in einer geraden Reihe gewährleistet wird. Die Erfindung zielt ferner darauf ab, ein entsprechendes Bauelement zu schaffen.

Die Erfindung erreicht dies in Hinsicht auf das erfindungsgemäße Verfahren durch den Gegenstand des Anspruches 1.

Schließlich wird nach einer Variante der Erfindung die Zentriereinrichtung am Bestückungskopf eines Bestückungswerkzeuges ausgebildet und dazu verwendet, einen bereits auf die Leiterplatte aufgesetzten Bauelementabschnitt beim Absetzen eines weiteren Bauelementabschnittes auf die Leiterplatte zu ergreifen und den weiteren auf die Leiterplatte aufzusetzenden Bauelementabschnitt durch Selbstausrichtung des Bestückungskopfes beim Ergreifen des bereits montierten Bauelementabschnittes auszurichten. Die Erfindung schafft somit auch eine vorteilhafte Neuerung auf dem Gebiet der Bestückungsköpfe für Bestückungsautomaten von Leiterplatten. Vorzugsweise weist der Ansatz mit dem Vorsprung einen konischen Bereich auf, der den Montagevorgang als Vorzentrierung sicherstellt. Möglich ist schließlich auch eine Ausbildung zum Auf- und/oder Ansetzen seitlich geschlossener Bauelementabschnitte, insbesondere von Stiftleistenabschnitten sowie eine Kontur- oder Formgebung, welche der Kontur eines aufzunehmenden Bauelementes angepaßt ist.

Weitere vorteilhafte Ausgestaltungen der Erfindung sind den übrigen Unteransprüchen zu entnehmen.

Nachfolgend wird die Erfindung unter Bezug auf die Zeichnung anhand von Ausführungsbeispielen näher beschrieben. Es zeigt:
- Fig. 1: ein erstes Ausführungsbeispiel eines Stiftleistenabschnittes zur Bildung einer Stiftleiste auf einer Leiterplatte;
- Fig. 2: ein zweites Ausführungsbeispiel eines Stiftleistenabschnittes zur Bildung einer Stiftleiste auf einer Leiterplatte;
- Fig. 3: ein drittes Ausführungsbeispiel eines Stiftleistenabschnittes zur Bildung einer Stiftleiste auf einer Leiterplatte;
- Fig. 4a,b: verschiedene Stadien bei der Montage von Stiftleistenabschnitten auf einer Leiterplatte nach einer ersten Variante des erfindungsgemäßen Verfahrens;
- Fig. 5: verschiedene Stadien bei der Montage von Stiftleistenabschnitten auf einer Leiterplatte nach einer zweiten Variante des erfindungsgemäßen Verfahrens;
- Fig. 6: verschiedene Stadien bei der Montage von Stiftleistenabschnitten auf einer Leiterplatte nach einer dritten Variante des erfindungsgemäßen Verfahrens.

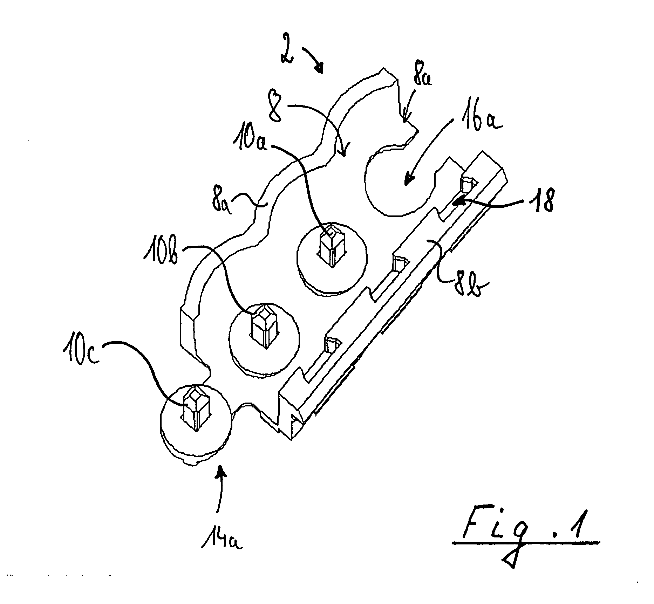

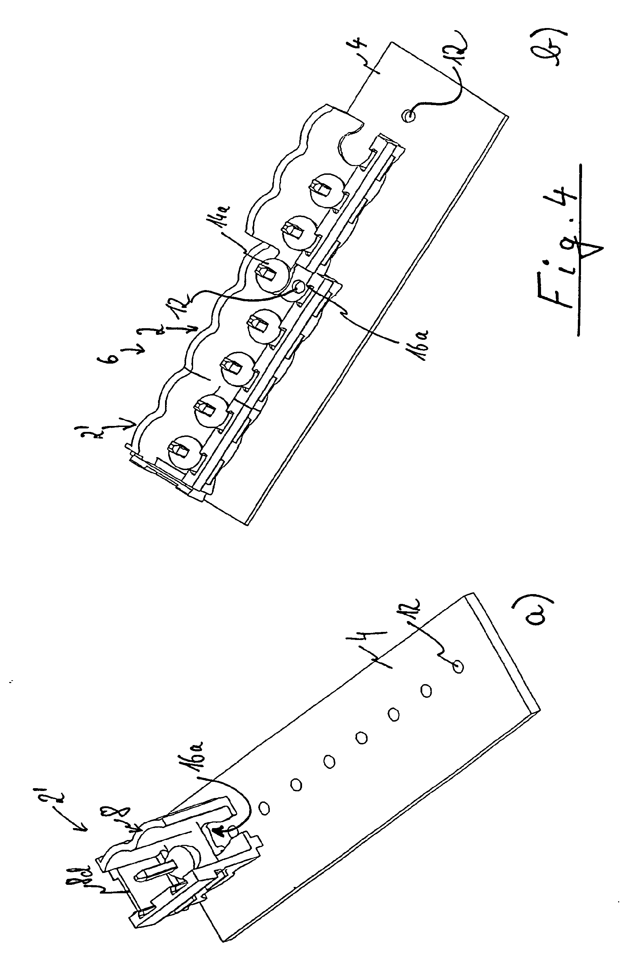

Fig. 1 zeigt einen Stiftleistenabschnitt 2, aus dem auf einer Leiterplatte 4 (siehe z.B. Fig. 4) eine übergreifende, zusammengehörige mehrpolige (insbesondere auch hochpolige) Stiftleiste 6 (siehe wiederum Fig. 4) zusammensetzbar ist.

Der Stiftleistenabschnitt 2 weist ein Gehäuse 8 mit einer langezogenen und im Querschnitt zur Längsrichtung im wesentlichen U-förmigen Gestaltung auf. In die Grundwandung 8a des U sind drei in einer Reihe angeordnete Steckerstifte bzw. Pins 10a-c eingesetzt, welche die Grundwandung 8a beidseitig durchsetzen, wobei die auf der Außenseite des U liegenden Stiftabschnitte zum Eingriff ein Öffnung und/oder Bohrung 12 (siehe Fig. 4) der Leiterplatte 4 vorgesehen sind, in der die Stifte befestigt (z. B. verlötet) werden.

An seinen beiden Enden ist der Stiftleistenabschnitt 2 mit einer Zentriereinrichtung versehen, die aus Zentrierungselementen 14a, 16a besteht, mit denen die Stiftleistenabschnitte 2 beim Aneinanderreihen auf der Leiterplatte in einer Reihe ausgerichtet werden. An einer der Längsseiten ist dazu an den Stiftleistenabschnitt 2 ein im wesentlichen kreisrunder Grundwandungsansatz bzw. - vorsprung 14a und an der anderen Seite eine annähernd kreisrunde Grundwandungsausnehmung 16a ausgebildet. Der Grundwandungsvorsprung 14a ist dazu ausgelegt, in die korrespondierende Grundwandungsausnehmung 16a kreisrunder Form am anderen Ende eines benachbarten Stiftleistenabschnittes 2' einzugreifen (siehe wiederum Fig. 4).

Die beiden zueinander im wesentlichen "parallel" ausgerichteten Seiten 8b, 8c des U-förmigen Gehäuses 8 weisen unterschiedliche Formgebungen auf. So ist eine der Seiten - die Seite 8a - leicht gewellt ausgelegt, um derart eine Art Sitz für eine entsprechend ausgebildete Steckerbuchse zu bilden. Die gegenüberliegende Seite des U ist dagegen im wesentlichen eben ausgerichtet, wobei die ansonsten ebene Fläche aber mit parallel zur Stiftrichtung versehen Schwalbenschwanzausnehmungen 18 versehen ist, die ebenfalls als Zentrierungselemente nutzbar sind, die aber auch als Führungselemente für eine Steckerbuchse dienen können.

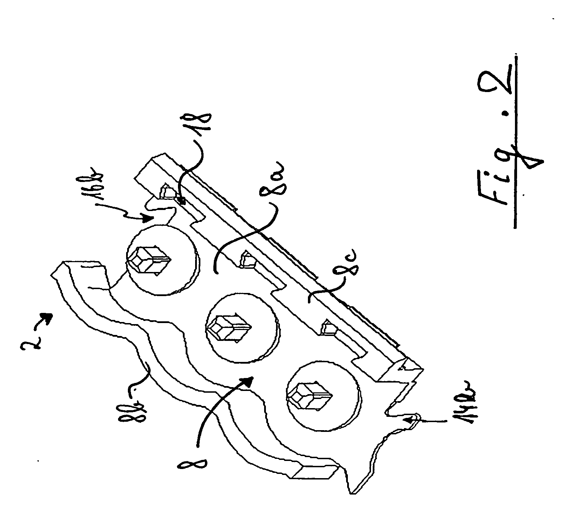

Von Fig. 1 unterscheidet sich das Ausführungsbeispiel der Fig. 2 lediglich dadurch, daß anstelle der kreisrund ausgebildeten Zentrierungselemente "V- oder schwalbenschwanzförmige" Grundwandungsansätze bzw. - vorsprünge 14b und Ausnehmungen 16b vorgesehen sind.

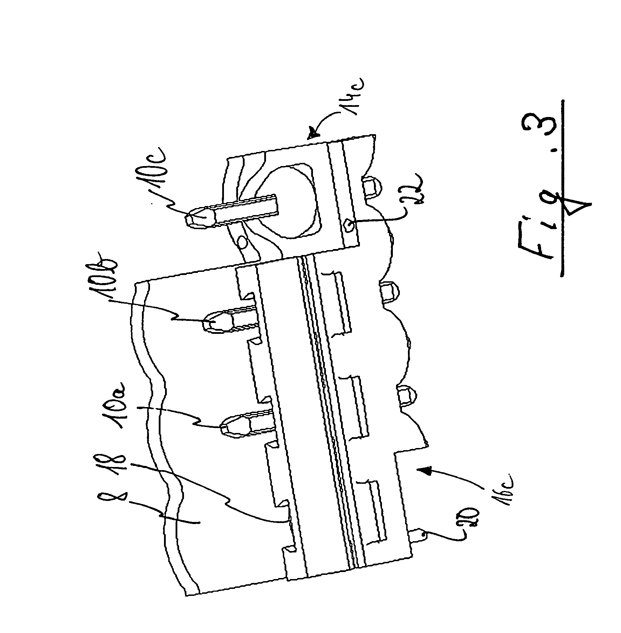

Das Ausführungsbeispiel der Fig. 3 unterscheidet sich hiervon dadurch, daß die Grundwandungsansätze bzw. - vorsprünge als im wesentliche rechteckige Vorsprünge 14c ausgebildet sind, deren Breite der Breite des gesamten Stiftleistensabschnittes 2 entsprechen, wobei die Stiftleistenabschnitte 2 im Bereich der ebenfalls rechteckigen Grundwandungsausnehmung 16c zusätzlich mit senkrecht von den Seitenwandungen 8b, 8c nach unten abstehenden Stiften 20 versehen sind, welche zum Eingriff in entsprechende Ausnehmungen 22 in den Vorsprüngen 14c dienen.

Dieses Ausführungsbeispiel hat im besonderen den Vorteil, daß eine besonders sichere Zentrierungsart realisiert wird.

Die erfindungsgemäße Montage erfolgt - siehe hierzu zunächst Fig. 4a - mit den Varianten der Fig. 1 bis 3 wie folgt: Zunächst wird ein erster "Abschluß-Stiftleistenabschnitt" 2' auf die Leiterplatte 4 aufgesetzt, wobei jeweils die unteren Stiftstücke in die Öffnungen 12 der Leiterplatte eingreifen, wo sie entweder sofort oder vorzugsweise nach dem Setzen aller Bauelemente verlötet werden. Der erste "Abschluß-Stiftleistenabschnitt" 2' ist an einem seiner beiden U-förmigen Enden hier beispielhaft mit einer Gehäuseabschlußwandung 8d versehen. An dem der Abschlußwandung 8d gegenüberliegenden Ende weist der Abschluß-Stiftleistenabschnitt 2' die Ausnehmung 16a auf, in welche der Vorsprung 14a eines anzureihenden Stiftleiterabschnittes 2 einfügbar ist (siehe Fig 4b). Beim Ineinanderfügen der Zentrierungselemente 14, 16 richtet sich der nachfolgende Stiftleistenabschnitt 2 jeweils am vorhergehenden Stiftleistenabschnitt "selbsttätig" aus, so daß stets gewährleistet ist, daß die Stiftleiste 6 unkompliziert auf der Leiterplatte 4 zusammenstellbar ist. An der dem Abschluß-Stiftleistenabschnitt 2' gegenüberliegenden Ende der Stiftleiste 6 ist ein entsprechender Abschluß-Stiftleistenabschnitt (hier nicht dargestellt) vorzusehen, der mit einem Vorsprung 14b als Zentrierelement versehen ist.

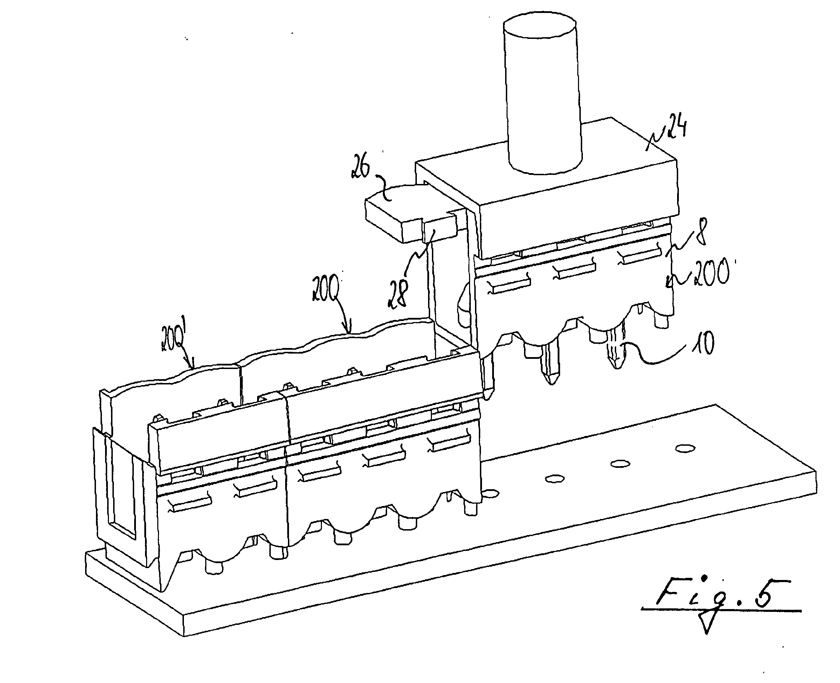

Eine weitere Variante des erfindungsgemäßen Verfahrens zeigt Fig. 5. Nach dieser Variante der Erfindung ist die Zentriereinrichtung am Bestückungskopf 24 eines Bestückungswerkzeuges bzw. -automaten (hier ansonsten nicht dargestellt) ausgestaltet. Sie ist als Ansatz 26 des Bestückungskopfes 24 ausgebildet und mit einem Schwalbenschwanzvorsprung 28 versehen, der zum Eingriff in die seitlichen Schwalbenschwanzausnehmungen 18 der Stiftleistenabschnitte 200 ausgelegt ist, deren Gehäuse 8 ansonsten keinerlei Zentrierungselemente aufweisen. Nach dem Absetzen eines ersten Abschluß-Stiftleistenabschnittes 200' wird jeweils beim Absetzen eines nachfolgenden Stiftleistenabschnittes 200 der Ansatz 26 des Bestükkungskopfes 24 mit seinem Schwalbenschwanzvorsprung 28 in die seitlichen Schwalbenschwanzausnehmungen 18 des vorhergehenden Stiftleistenabschnittes 200 geführt, wodurch die Stiftleistenabschnitte 200 in einer Reihe ausgerichtet werden und wiederum eine übergreifende Stiftleiste 6 bilden.

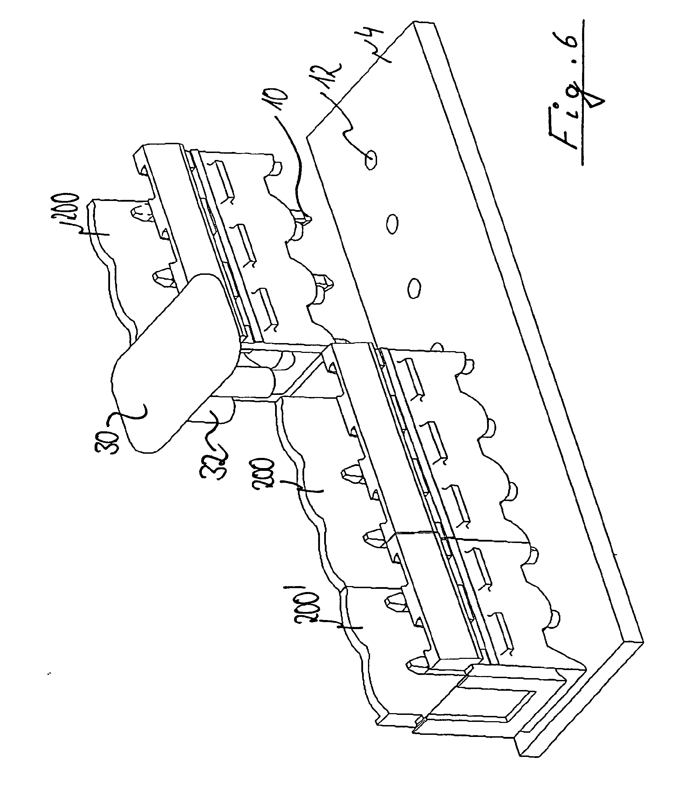

Nach Fig. 6 werden dagegen als Zentrierungselemente sogenannte "Pick-and-Place-Pads 30 eingesetzt, die mit unteren Beinchen 32 versehen sind, anhand deren Eingriff in einen jeweils vorhergehenden Stiftleistenabschnitt 200 beim Absenken des Bestückungskopfes 24 die Ausrichtung der Stiftleistenabschnitte 200 zur übergreifenden Stiftleiste 6 erfolgt. Nach dem Aufsetzen der Stiftleistenabschnitte und dem Verlöten auf der Leiterplatten lassen sich die Pick-and-Place-Pads ohne weiteres von den Stiftleistenabschnitten 200 abziehen.

Zur vereinfachten Montage können die Zentrierungselemente 14, 16 der Stiftleisten bzw. die Elemente 20 bzw. die des Bestückungskopfes 28 konisch ausgelegt sein.

### Bezugszeichenliste

- Stiftleistenabschnitt: 2,2',200,200'
- Leiterplatte: 4
- Stiftleiste: 6
- Gehäuse: 8
- Gehäusewandungen: 8a-d
- Steckerstifte: 10
- Bohrung: 12
- Zentrierungselemente: 14, 16
- Grundwandungsvorsprung: 14a,b,c
- Grundwandungsausnehmung: 16a,b,c
- Schwalbenschwanzausnehmungen: 18
- Stifte: 20
- Ausnehmungen: 22
- Bestückungskopf: 24
- Ansatz: 26
- Schwalbenschwanzvorsprung: 28
- Pick-and-Place-Pads: 30
- Beinchen: 32

## Patentansprüche

1. Verfahren zur Montage elektrischer aktiver oder passiver Bauelemente aus Bauelementabschnitten auf einer Leiterplatte.
a. wobei die Bauelementabschnitte Leiterplattenklemmenahschnitte, Buchsenleistenabschnitte, Stiftleistenabschnitte und die Bauelemente Leiterplattenklemmen, Buchsenleiste oder Stiftleisten sind, wobei aus den jeweiligen Bauelementabschnitten direkt auf der Leiterplatte die übergreifenden Bauelemente zusammengereiht werden.
b. wobei ein nachfolgender Bauelementabschnitt an einem vorhergehend auf die Leiterplatte aufgesetzten Bauelementabschnitt auf der Leiterplatte ausgerichtet wird und
i. wobei die Zentriereinrichtung an den Bauelementabschnitten puzzleartig ausgebildete Zentrierungselemente aufweist, an denen die die Bauelementabschnitte beim Aneinanderreihen auf der Leiterplatte in einer Reihe ausgerichtet werden,
ii. oder wobei als Zentrierungselemente der Bauelementabschnitte an die Bauelementabschnitte, insbesondere die Stiftleistenabschnitte, ansetzbare und von diesen lösbare Rahmen oder Kämme oder Pick-and-Place-Pads verwendet werden.
iii. oder wobei die Zentriereinrichtung als Zentrierelement am Bestückungskopf eines Bestückungswerkzeuges ausgebildet ist und dazu verwendet wird, einen bereits auf die Leiterplatte aufgesetzten Bauelementabschnitt beim Absetzen eines weiteren Bauelementabschnittes auf die Leiterplatte zu ergreifen und den weiteren auf die Leiterplatte aufzusetzenden Bauelementabschnitt durch Selbstausrichtung des Bestückungskopfes beim Ergreifen des bereits montierten Bauelementabschnittes auszurichten..

2. Montageverfahren nach Anspruch 1, **dadurch gekennzeichnet, daß** die Bauelementabschnitte auf der Leiterplatte mittels einer Zentriereinrichtung positioniert und auf der Leiterplatte in einer Reihe ausgerichtet werden.

3. Montageverfahren nach Anspruch 1 oder 2, **dadurch gekennzeichnet, daß** als Zentrierungselemente der Bauelementabschnitte miteinander korrespondierende Schwalbenschwanzausnehmungen und -vorsprünge und/oder miteinander korrespondierende T-förmige und/oder V-förmige und/oder kreisförmige und/oder konische, ineinandersetzbare Ausnehmungen und Vorsprünge und/oder zusammenwirkende Nuten und Federn verwendet werden.

4. Montageverfahren nach einem der vorstehenden Ansprüche, **dadurch gekennzeichnet, daß** die Zentrierungselemente benachbarter Bauelementabschnitte auf der Leiterplatte jeweils eine korrespondierend sich verjüngende Querschnittsgeometrie aufweisen, so daß sich die Zentrierungselemente benachbarter Bauelemente selbsttätig auf der Leiterplatte beim Zusammenführen aneinander ausrichten.

5. Montageverfahren nach einem der vorstehenden Ansprüche, **dadurch gekennzeichnet, daß** die Zentrierungselemente und/oder -ausnehmungen als Bohrungen, Freimachungen oder Aussparungen und hierzu korrespondierende Vorsprünge an den Bauelementen und/oder den Leiterplatten ausgebildet werden.

6. Bestückungskopf eines Bestückungswerkzeuges zur Bildung eines Bauelementes, insbesondere einer Stiftleiste, **gekennzeichnet durch** ein Zentrierelement (26), daß dazu ausgelegt ist, einen bereits auf die Leiterplatte aufgesetzten Bauelementabschnitt beim Absetzen eines weiteren Bauelementabschnittes auf die Leiterplatte zu ergreifen und den weiteren auf die Leiterplatte aufzusetzenden Bauelementabschnitt **durch** Selbstausrichtung des Bestückungskopfes beim Ergreifen des bereits montierten Bauelementabschnittes auszurichten.

7. Bestückungskopf nach Anspruch 6, **gekennzeichnet durch** einen Ansatz (26) mit einem Vorsprung (28) zum Eingriff in eine Ausnehmung (18) eines Bauelementabschnittes (200).

8. Bestückungskopf nach Anspruch 6, **dadurch gekennzeichnet, daß** der Ansatz (26) mit dem Vorsprung (28) einen konischen Bereich aufweist, der den Montagevorgang als Vorzentrierung sicherstellt.

9. Bestückungskopf nach einem der vorstehenden Ansprüche 6 bis 8, **gekennzeichnet durch** eine Ausbildung zum Auf- und/oder Ansetzen seitlich geschlossener Bauelementabschnitte.

10. Bestückungskopf nach einem der vorstehenden Ansprüche 6 bis 9, **gekennzeichnet durch** eine Kontur, welche der Kontur eines aufzunehmenden Bauelementabschnittes angepaßt ist.

## Claims

1. Method for fitting electrically active or passive components consisting of component sections onto a printed circuit board,
a. in which the component sections are printed circuit terminal sections, socket strip sections or contact-pin strip sections and the components are printed circuit terminals, socket strips or contact-pin strips, such that of the respective component sections the overlapping components are aligned together on the printed circuit board,
b. such that a subsequent component section is aligned on the printed circuit board with a component section previously fitted on the printed circuit, and
i. such that the centring device on the component sections has centring elements designed in the manner of a jigsaw puzzle, by which the component sections are aligned in a row on the printed circuit board when positioned one after another,
ii. or such that as centring elements of the component sections, frames that can be put on and removed from the component sections, in particular the contact-pin strip sections, or combs, or pick-and-place pads are used,
iii. or such that the centring device is formed as a centring element on the mounting head of a mounting tool and is used, when a component section has already been fitted on the printed circuit board, to grip it when a further component section is to be placed on the printed circuit board, and to align the said further component section to be placed on the printed circuit board by self-alignment of the mounting head as it grips the already fitted component section.

2. Fitting method according to Claim 1, **characterised in that** the component sections are positioned on the printed circuit board by means of a centring device and are aligned in a row on the printed circuit board.

3. Fitting method according to Claims 1 or 2, **characterised in that** as centring elements for the component sections, mutually corresponding dovetail recesses and projections and/or mutually corresponding T-shaped and/or V-shaped and/or circular and/or conical recesses and projections that can be fitted one into another, and/or co-operating grooves and springs are used.

4. Fitting method according to any of the preceding claims, **characterised in that** the centring elements of adjacent component sections on the printed circuit board have in each case a corresponding, tapering cross-section geometry, such that the centring elements of adjacent component sections automatically align with one another on the printed circuit board when they are brought together.

5. Fitting method according to any of the preceding claims, **characterised in that** the centring elements and/or recesses are formed as bores, clearances or recesses and projections on the components and/or on the printed circuits that correspond to them.

6. Mounting head of a mounting tool for forming a component, in particular a contact-pin strip, **characterised by** a centring element (26) designed such that it grips a component section already positioned on the printed circuit board during the positioning of a further component section on the printed circuit board, and while gripping the already positioned component section, aligns the component section being positioned by self-alignment.

7. Mounting head according to Claim 6, **characterised by** an attachment (26) with a projection (28) for engaging in a recess (18) of a component section (200).

8. Mounting head according to Claim 6, **characterised in that** the attachment (26) with the projection (28) has a conical zone which ensures a correct mounting process as a pre-centring means.

9. Mounting head according to any of the preceding Claims 6 to 8, **characterised by** a design enabling the mounting and/or positioning of component section with closed sides.

10. Mounting head according to any of the preceding Claims 6 to 9, **characterised by** a contour adapted to the contour of a component section to be held.

## Revendications

1. Procédé pour monter des composants actifs ou passifs électriques à base de parties de composant sur une carte imprimée,
a. les parties de composant étant des parties de borne de carte imprimée, des parties de connecteur femelle, des parties d'embase mâle et les composants étant des bornes de carte imprimée, des connecteurs femelles ou des embases mâles, les composants de chevauchement étant alignés ensemble à base des parties de composant respectives directement sur la carte imprimée,
b. une partie de composant consécutive étant orientée sur la carte imprimée sur une partie de composant posée auparavant sur la carte imprimée et
i. le dispositif de centrage présentant des éléments de centrage réalisés à la façon d'un puzzle sur les parties de composant, éléments sur lesquels les parties de composant sont orientées lors de l'alignement sur la carte imprimée dans une rangée,
ii. ou des cadres ou des peignes ou des pick-and-place-pads pouvant être ajoutés sur les parties de composant, en particulier les parties d'embase mâle, et pouvant être détachés de ceux-ci étant utilisés comme éléments de centrage des parties de composant,
iii. ou le dispositif de centrage étant conçu comme élément de centrage sur la tête d'équipement d'un outil d'équipement et utilisé pour saisir une partie de composant déjà posée sur la carte imprimée lors de la dépose d'une autre partie de composant sur la carte imprimée et aligner l'autre partie de composant à poser sur la carte imprimée par auto-orientation de la tête d'équipement lors de la saisie de la partie de composant déjà montée.

2. Procédé de montage selon la revendication 1, **caractérisé en ce que** les parties de composant sont positionnées sur la carte imprimée au moyen d'un dispositif de centrage et sont orientées sur la carte imprimée dans une rangée.

3. Procédé de montage selon la revendication 1 ou 2, **caractérisé en ce que**, comme éléments de centrage des parties de composant, on utilise des évidements et des saillies en queue d'aronde correspondant les uns avec les autres et/ou des évidements et saillies en forme de T et/ou de V et/ou circulaires et/ou coniques, emboîtables, correspondant les uns avec les autres et/ou des rainures et des languettes interactives.

4. Procédé de montage selon l'une quelconque des revendications précédentes, **caractérisé en ce que** les éléments de centrage de parties de composant voisines sur la carte imprimée présentent chacun une géométrie de section se rétrécissant de façon correspondante, de sorte que les éléments de centrage de composants voisins s'alignent automatiquement les uns sur les autres sur la carte imprimée lors du regroupement.

5. Procédé de montage selon l'une quelconque des revendications précédentes, **caractérisé en ce que** les éléments de centrage et/ou les évidements de centrage sont conçus sous forme de perçages, d'évidements ou de creux et de saillies correspondant à ceux-ci sur les composants et/ou les cartes imprimées.

6. Tête d'équipement d'un outil d'équipement pour former un composant, en particulier une embase mâle, **caractérisée par** un élément de centrage (26), qui est conçu pour saisir une partie de composant déjà posée sur la carte imprimée lors de la dépose d'une autre partie de composant sur la carte imprimée et orienter l'autre partie de composant à poser sur la carte imprimée par l'auto-orientation de la tête d'équipement lors de la saisie de la partie de composant déjà montée.

7. Tête d'équipement selon la revendication 6, **caractérisée par** un appendice (26) avec une saillie (28) pour l'engagement dans un évidement (18) d'une partie de composant (200).

8. Tête d'équipement selon la revendication 6, **caractérisée en ce que** l'appendice (26) avec la saillie (28) présente une zone conique qui garantit l'opération de montage comme précentrage.

9. Tête d'équipement selon l'une quelconque des revendications 6 à 8 précédentes, **caractérisée par** une conception pour la pose par-dessus et/ou par le côté de parties de composant fermées latéralement.

10. Tête d'équipement selon l'une quelconque des revendications 6 à 9 précédentes, **caractérisée par** un contour qui est adapté au contour d'une partie de composant à recevoir.
